# EUROPEAN PATENT APPLICATION

(11) **EP 1 696 486 A1**
(43) Date of publication of application: **30.08.2006**
(21) Application number: 06003505.2
(22) Date of filing: 21.02.2006
(51) Int. Cl.: H01L 23/552

(54) **Integrated circuit and wireless ic tag**

(30) Priority: 25.02.2005 JP 2005051613
(71) Applicant: FUJI PHOTO FILM CO., LTD., Minami-Ashigara-shi, Kanagawa-Ken 250-0193 (JP)
(72) Inventor: Kamiya, Takeshi, Ashigarakami-gun Kanagawa-ken 258-8538 (JP)
(74) Representative: Höhfeld, Jochen

(57) **Abstract**

In a wireless IC tag (10), on which an integrated circuit (12) and a small antenna (40) are integrally mounted, a radiation-shielding material (22) covers only the integrated circuit (IC chip) (12) portion. Thus, the area of the small antenna (40) covered by the radiation-shielding material (22) is minute, and it is possible to minimally suppress a reduction in antenna gain of the small antenna. Such a wireless IC tag (10) has radiation-shielding properties.

## Description

### BACKGROUND OF THE INVENTION

### Field of the Invention:

The present invention relates to an integrated circuit (IC) having a package in which an IC chip is installed, and a wireless IC tag on which such an integrated circuit is mounted.

### Description of the Related Art:

Conventionally, it has been known that integrated circuits malfunction and properties thereof deteriorate when exposed to radiation (see, Japanese Laid-Open Patent Publication No. 2003-75545).

Japanese Laid-Open Patent Publication No. 2003-75545 discloses a radiation detector including a planar support member having fixed thereon a planar sensor unit for converting radiation emitted by a radiation source into electrical signals, and an IC-mounting substrate disposed in a facing relationship to the support member, with a constant distance therebetween. The sensor unit and the IC-mounting substrate are electrically connected via a flexible substrate.

In the radiation detector having the above-mentioned structure, when radiation is applied to the sensor unit, radiation is transmitted through the sensor unit, and then applied to each of a plurality of integrated circuits mounted on the IC-mounting substrate through the support member. In view thereof, the radiation detector disclosed in Japanese Laid-Open Patent Publication No. 2003-75545 further includes a plurality of radiation shielding materials fixed to the support member, in respective areas which, when viewed from above, are of the same width or wider than the corresponding plural integrated circuits, in order to prevent each of the plurality of integrated circuits from being exposed to radiation through the sensor unit.

However, in the radiation detector disclosed in Japanese Laid-Open Patent Publication No. 2003-75545, because the IC-mounting substrate is disposed at a certain distance from the support member of the sensor unit, a disadvantage results in that the radiation shielding material must have a relatively large area in order to function as a reliable radiation shield.

Because the radiation-shielding material is made of a metal such as lead, when the area of the radiation-shielding material is made large, the weight of the detector itself increases undesirably.

Further, because the support member to which the radiation shielding materials are fixed is disposed at a certain distance from the IC-mounting substance, a problem occurs in that the radiation shielding materials must be disposed over larger area in order to provide tolerances for dimensional errors during installation.

On the other hand, in recent years, in place of bar codes or the like, a wireless IC tag (also referred to as an RFID tag or an electronic tag) has been adopted as an identification and control method. A wireless IC tag integrally includes an integrated circuit (IC), formed as a package in which an IC chip is installed together with a small antenna.

When such a wireless IC tag is exposed to radiation, the integrated circuit therein is also exposed to radiation, causing the wireless IC tag to malfunction or causing the characteristics thereof to deteriorate. When a radiation shielding material is used to cover the entire wireless IC tag, the characteristics of the small antenna tend to deteriorate undesirably, and the wireless communication distance provided thereby becomes significantly shortened.

### SUMMARY OF THE INVENTION

In view of the above problems, an object of the present invention is to provide an integrated circuit (IC), wherein the properties thereof will not deteriorate when exposed to radiation. Another object of the present invention is to provide a wireless IC tag, on which such an integrated circuit is mounted.

An integrated circuit of the present invention includes a package in which an IC chip is installed. The package integrally comprises a radiation-shielding material for attenuating external radiation applied to the IC chip.

Because the radiation-shielding material is integrally disposed in the package containing the IC chip, the distance between the IC chip and the radiation-shielding material may be on the order of millimeters, enabling the IC chip to be effectively shielded from radiation.

The radiation-shielding material is preferably installed within the package or attached to a surface of the package.

In this case, the radiation shielding material preferably is substantially the same size as the IC chip.

A package containing the radiation shielding material as an ingredient thereof makes it possible to shorten the manufacturing time for an integrated circuit providing a radiation-shielding effect. Further, the number of components forming the integrated circuit can be reduced, since a separate radiation-shielding component is not required.

Because the radiation-shielding material covers only the integrated circuit (IC chip) portion within the wireless IC tag, on which the radiation-shielded integrated circuit and a small antenna are integrally mounted, the area of the small antenna covered by the radiation shielding material is extremely small, making it possible to minimally suppress a reduction in antenna gain of the small antenna.

According to the present invention, it is possible to produce an integrated circuit (IC), in which deterioration in the properties thereof is minimized when exposed to radiation, as well as to produce a wireless IC tag comprising such an integrated circuit. Because the wireless IC tag is composed of an integrated circuit including a small antenna and a package in which an IC chip is installed, properties of the IC tag are less prone to deterioration when exposed to radiation.

The above and other objects, features, and advantages of the present invention will become more apparent from the following description when taken in conjunction with the accompanying drawings in which preferred embodiments of the present invention are shown by way of illustrative example.

### BRIEF DESCRIPTION OF THE DRAWINGS

FIG. 1 is a plan view showing a wireless IC tag according to an embodiment of the present invention;
FIG. 2 is a cross-sectional view, with partial omission, showing an integrated circuit (IC) as part of the wireless IC tag according to the embodiment of the present invention, taken along line II-II in FIG. 1;
FIG. 3 is a cross-sectional view, with partial omission, showing an integrated circuit (IC) according to another embodiment of the present invention;
FIG. 4 is a table showing the relationship between an amount of X-rays applied to the wireless IC tag and malfunctioning of the wireless IC tag;
FIG. 5 is a table showing the relationship between an attachment state of the radiation shielding material, as applied to the wireless IC tag or the IC chip, and readability of identification stored in the wireless IC tag by a reader/writer; and
FIG. 6 is a cross-sectional view, with partial omission, showing an integrated circuit according to a further embodiment of the present invention.

### DESCRIPTION OF THE PREFERRED EMBODIMENTS

The present invention will be explained below with reference to the attached drawings.

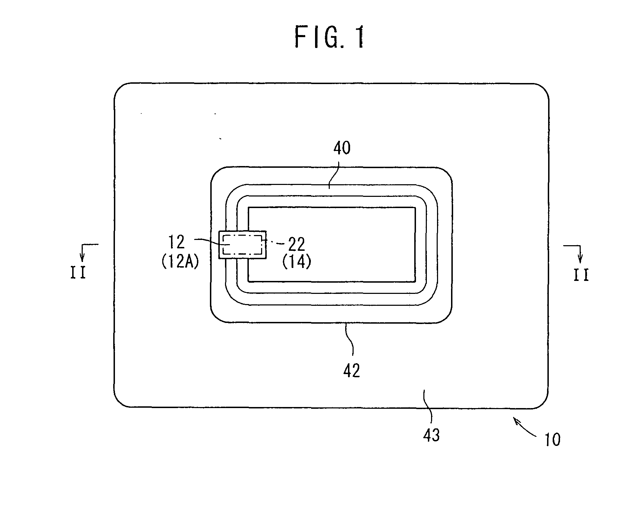

FIG. 1 is a plan view showing a wireless IC tag 10 according to an embodiment of the present invention.

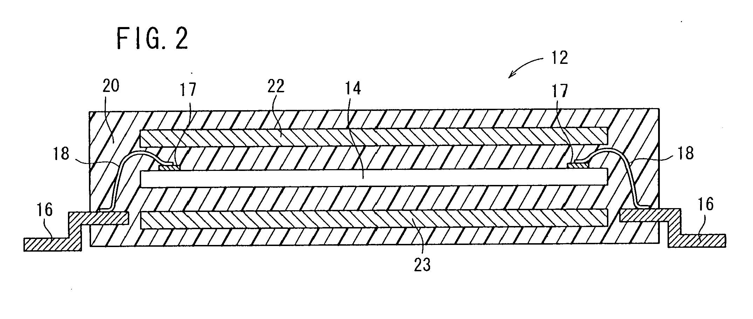

FIG. 2 is a cross-sectional view, with partial omission, of an integrated circuit (IC) 12 as part of the wireless IC tag according to the embodiment of the present invention, taken along line II-II in FIG. 1.

As shown in FIG. 2, the integrated circuit 12 includes an IC chip 14 having a digital processing unit and a nonvolatile memory (not shown). The IC chip 14 is incorporated into a package 20 by molding, while electrodes 17 on the IC chip 14 are electrically connected to lead frames 16 by wires 18.

In the integrated circuit 12, plate-like radiation-shielding materials 22, 23 are integrally formed inside the package 20 in order to attenuate radiation to which the IC chip 14 is exposed.

Specifically, the radiation-shielding materials 22, 23 sandwich the plate-like IC chip 14 such that the radiation-shielding materials 22, 23 cover both sides of the IC chip 14, taking the effects of backscattering into consideration. In cases where backscattering is weak, only one of the radiation-shielding materials 22, 23 may be sufficient, when disposed on the side of the IC chip 14 which is exposed to radiation.

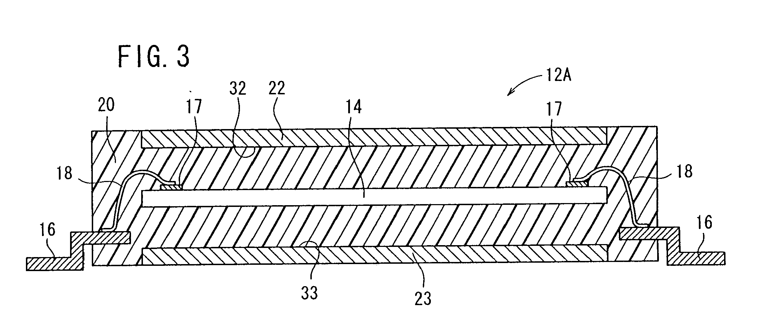

In another embodiment of an integrated circuit 12A, as shown in FIG. 3, the radiation-shielding materials 22, 23 may be placed in recesses 32, 33 formed on both surfaces of the package 20, and attached thereto by an adhesive.

In both embodiments, the radiation-shielding materials 22, 23 are of substantially the same size as the IC chip 14, when viewed from above (see, FIGS. 1 and 2).

As shown in FIG. 1, the wireless IC tag 10 is composed of a printed-wiring board 42, on which the integrated circuit 12 (12A) and a small antenna 40 such as a loop antenna are formed, and a support 43 formed by a resin plate or the like, to which the printed-wiring board 42 is attached. In actual use, the wireless IC tag 10 has a laminated structure, wherein the printed-wiring board 42 with the integrated circuit 12 (12A) mounted thereon is interposed between laminated supports 43.

Data are written to or read out from the integrated circuit 12 (12A) of the wireless IC tag 10 by a reader/writer (not shown).

Metals having an atomic number of 50 or greater may be used as radiation-shielding materials 22, 23, taking into account the fact that the amount of X-rays absorbed by a substance is proportional to the cube of its atomic number. Examples of such metals include lead, tin, antimony, bismuth, etc. In the present embodiment, lead having a thickness of 0.5 mm is used for the radiation-shielding materials 22, 23. However, no limitation is imposed on the thickness of the radiation-shielding materials 22, 23, so long as such materials are capable of effectively shielding radiation and achieving reliable operation of the integrated circuits 12, 12A. The thickness of the metals should be determined based on the actual amount of radiation (in aggregate) applied to the integrated circuit 12 (12A), and the performance and durability of the system in which the wireless IC tag 10 is intended to be used.

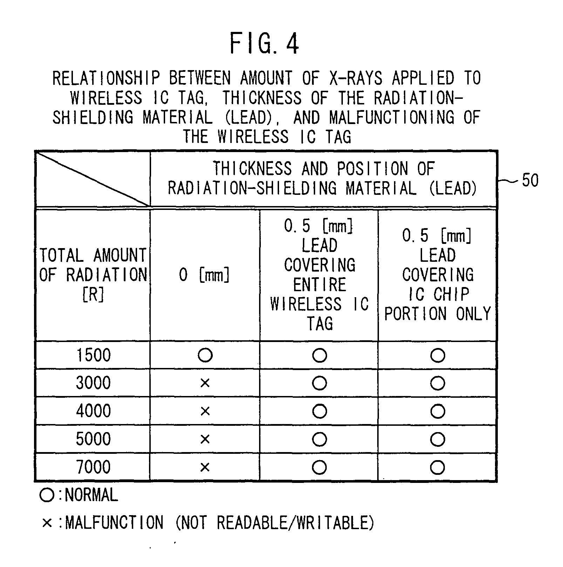

FIG. 4 is a table 50 showing the relationship between the total amount of X-rays applied to the wireless IC tag and malfunctioning of the wireless IC tag or the integrated circuit mounted therein. The total amount of X-rays (aggregate X-rays) applied to the wireless IC tag was set at respective levels of 1500, 3000, 4000, 5000 and 7000 R. Functionality of the wireless IC tag and the integrated circuit thereof was judged based on whether or not data could be read out or written to the integrated circuit using a reader/writer. Radiation-shielding materials made of the same material forming the radiation-shielding materials 22, 23 were applied under the following conditions respectively: (A) closely and directly attached to a wireless IC tag having the integrated circuit mounted therein, such that the radiation shielding material covered the entire surface of the wireless IC tag, (B) closely and directly attached only to the integrated circuit, and (C) not attached at all to either the IC tag or to the integrated circuit thereof. In case (B), to be precise, although the size of the radiation shielding material was the same size as that of the IC chip 14, the size thereof was also substantially the same as that of the integrated circuit 12 (12A), when viewed from above.

As is clear from the table 50, the wireless IC tag having no radiation-shielding material (thickness of 0 mm) was both unreadable and unwritable (x) when the total amount of radiation applied thereto was 3000 R or more. However, even when no radiation-shielding material was provided (0 mm), the wireless IC tag was still readable and writable (o) when the total amount of radiation applied thereto was 1500 R or less. Further, in the case where a radiation-shielding material having a thickness of 0.5 mm was directly attached to the wireless IC tag so as to cover the entire surface thereof, or when the radiation-shielding material was directly attached so as only to cover the integrated circuit portion thereof, in both cases, the wireless IC tags were normally readable and writable (o) at least up to a total amount of applied radiation of 7000 R. Thus, from the experimental results shown in FIG. 4, it is clear that when a lead plate having a thickness of 0.5 mm is attached only to the integrated circuit portion, the IC tag does not malfunction, or suffer from deterioration in properties, even when exposed to radiation (X-ray radiation in the present embodiment) up to a total amount of radiation of at least 7000 R.

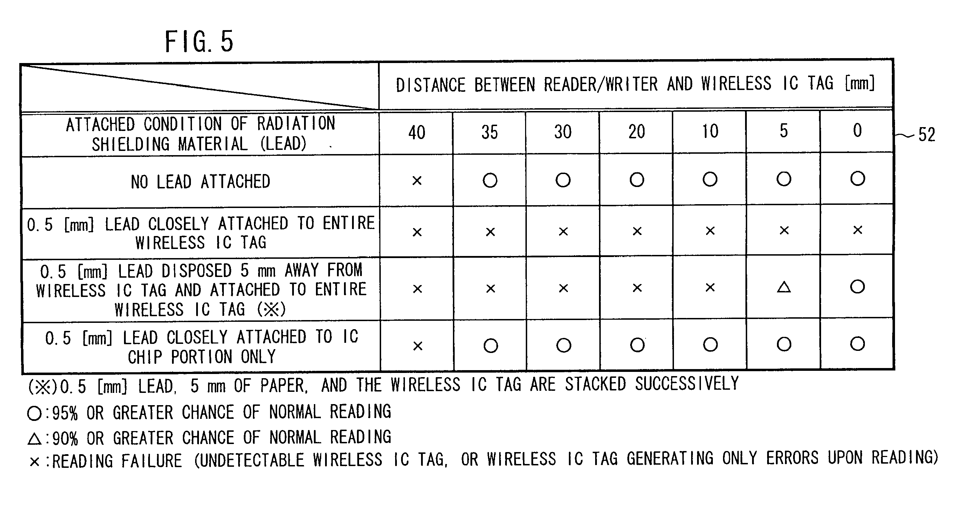

FIG. 5 is a table 52 showing the relationship between conditions of the radiation shielding material (lead) attached to the wireless IC tag, or to the integrated circuit portion thereof, and readability of identification information stored in the wireless IC tag when read by a reader/writer. Readability was judged based on the distance between the reader/writer and the wireless IC tag as a parameter. More specifically, the distance was set at 0, 5, 10, 20, 30, 35 and 40 mm respectively.

In FIG. 5, ○ represents a 95% or greater chance of normal reading, Δ represents approximately a 90% chance of normal reading, and x represents a reading failure, such as undetectable wireless IC tags, or wireless IC tags that generated only errors when reading was attempted.

When a lead radiation-shielding material was not attached to the IC tag in any manner, the wireless IC tag was readable at 95% or more within a distance of 0 to 35 mm.

When a radiation-shielding material made of lead and having a thickness of 0.5 mm was closely attached to the IC chip portion only of the IC tag, as shown in FIGS. 1 and 3, the wireless IC tag was still readable at 95% or more, within a distance of 0 to 35 mm, similar to the case when no lead material was attached.

Further, when a radiation-shielding material made of lead was closely attached to the wireless IC tag overall, or when the radiation-shielding material was disposed on the wireless IC tag via a piece of paper having a thickness of 5 mm, antenna gain was drastically decreased, so that the wireless IC tag was completely unreadable or possibly readable only at a close range (i.e., within 5 mm).

As is clear from FIG. 5, when lead having a thickness of 0.5 mm is attached only to the IC chip portion, that is, when the radiation-shielding material was disposed as in the integrated circuit 12A shown in FIG. 3, the radiation-shielding material does not hinder reading of data from the wireless IC tag using the reader/writer.

As mentioned above, in the integrated circuit 12 (12A), formed by a package 20 with an IC chip 14 installed therein, radiation-shielding materials 22, 23 for attenuating radiation applied externally to the IC chip 14 are integrally formed within the package 20. In such a structure, because the distance between the IC chip 14 and the radiation-shielding materials 22, 23 is on the order of millimeters, radiation can be effectively shielded.

Incidentally, the radiation-shielding materials 22, 23 may be installed inside the package 20, as shown in FIG. 2, or may be attached to the surface of the package 20, as shown in FIG. 3. In addition, the radiation-shielding materials 22, 23 may be substantially the same size as the integrated circuit 12 (12A). More specifically, when viewed from above, the radiation-shielding materials 22, 23 may have substantially the same shape as the IC chip 14.

In the above embodiment, an integrated circuit 12 (12A), and a wireless IC tag 10 including the integrated circuit 12 (12A) can be provided, wherein the properties thereof are not deteriorated due to radiation exposure.

As is commonly known, the wireless IC tag 10 includes an integrated circuit 12 (12A) formed by a package 20 having an IC chip 14 and a small antenna 40 installed therein. According to the present invention, the wireless IC tag 10 further includes radiation-shielding materials 22, 23 disposed therein so that the properties thereof are not subject to deterioration when exposed to radiation.

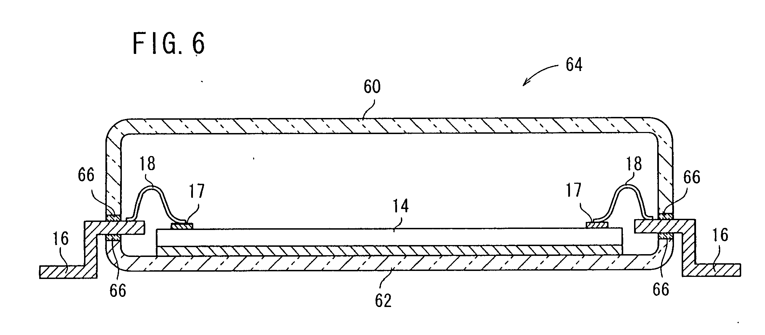

As shown in FIG. 6, when packages 60, 62 are formed, each of which contains a radiation shielding material as an ingredient thereof, an integrated circuit (IC) 64 having a radiation shielding property may be produced in less time. Examples of such packages 60, 62 include packages (i.e., radiation-shielding materials) made of alumina, which contains a radiation-shielding material as an ingredient thereof. Since the IC 64 shown in FIG. 6 does not require radiation-shielding materials 22, 23 as separate components thereof, the number of components making up the package can be reduced, as compared with the integrated circuits 12, 12A shown in FIGS. 1 to 3.

In the IC 64, the IC chip 14 is fixed to the lower package 62, and electrodes 17 of the IC chip 14 are connected to lead frames 16 via wires 18. Glass seals 66 are disposed at positions between the upper and lower packages 60, 62 and the lead frames 16.

As explained above, according to the above-described embodiments of the present invention, in the wireless IC tag 10 with the integrated circuit 12 (12A, 64) and the small antenna 40 integrally mounted therein and having radiation shielding properties, since the radiation-shielding materials 22, 23 (60, 62) cover only the integrated circuit (IC chip 14) portion, the radiation-shielding materials 22, 23 (60, 62) cover only a minute portion of the small antenna 40. Therefore, a reduction in antenna gain of the small antenna 40 can be suppressed minimally.

## Claims

1. An integrated circuit (12, 12A, 64) having a package (20, 60, 62) in which an IC chip (14) is installed, said package integrally comprising a radiation-shielding material (22, 23) for attenuating externally applied radiation on said IC chip.

2. The integrated circuit (12) according to claim 1, wherein said radiation-shielding material is installed in said package.

3. The integrated circuit (12A) according to claim 1, wherein said radiation-shielding material is attached to a surface of said package.

4. The integrated circuit (12, 12A) according to any one of claims 1 to 3, wherein said radiation-shielding material is substantially a same size as said IC chip.

5. The integrated circuit (64) according to claim 1, wherein said package (60, 62) contains a radiation-shielding material as an ingredient thereof.

6. A wireless IC tag (10) comprising the integrated circuit recited in any one of claims 1 to 5.
